# EUROPÄISCHE PATENTSCHRIFT

(11) **EP 1 719 393 B1**
(45) Veröffentlichungstag und Bekanntmachung des Hinweises auf die Patenterteilung: **30.12.2009**
(21) Anmeldenummer: 05700549.8
(22) Anmeldetag: 26.01.2005
(51) Int. Cl.: H05K 1/18, H05K 3/46

(54) **LEITERPLATTE**
PRINTED CIRCUIT BOARD
PLAQUETTE A CIRCUITS IMPRIMES

(30) Priorität: 28.02.2004 DE 102004009825
(43) Veröffentlichungstag der Anmeldung: 08.11.2006
(73) Patentinhaber: EADS Deutschland GmbH, 85521 Ottobrunn (DE)
(72) Erfinder: BÄRTELE, Marcus, 89077 Ulm (DE)
(74) Vertreter: Meel, Thomas
(86) Internationale Anmeldenummer: PCT/DE2005/000104
(87) Internationale Veröffentlichungsnummer: WO 2005/084091

(56) Entgegenhaltungen:
- EP-A- 1 111 674
- US-A- 5 877 550
- US-A1- 2003 035 275

## Beschreibung

Die Erfindung betrifft eine Anordnung zur Erhöhung der Bestückungsdichte einer Leiterplatte mit oberflächenmontierbaren elektrischen Bauteilen gemäß dem Oberbegriff des Patentanspruchs 1.

Es ist bekannt, dass zur Verkleinerung von Schaltungsaufbauten oberflächenmontierbare elektrische Bauteile (SMD - surface mounted devices) verwendet werden. Diese SMD-Bauteile werden dabei auf einer oder beiden Seiten einer Leiterplatte aufgebracht.. Ein Nachteil der Anordnung ist, dass auf Grund der steigenden Werte der zu verarbeitenden Frequenzen die Abstände der SMD-Bauteile zu groß sind. Damit ist ein erheblicher Schaltungsmehraufwand verbunden um zu große Signallaufzeiten zu kompensieren. Ein weiterer Nachteil dieser Anordnung ist, dass die Bestückungsdichte der Leiterplatte nicht beliebig erhöht werden kann. Somit sind der Bestückung einer Leiterplatte natürliche Grenzen in Form der geometrischen Ausmaße eines SMD-Bauteils gesetzt

Aus EP 1 139 705 A1 ist eine gattungsgemäße Leiterplatte bekannt. Die Leiterplatte besteht aus einem Kernsubstrat umfassend drei miteinander verpresste, elektrisch leitende Substrate, welche die elektrischen Bauelemente umschließen, sowie aus Kontaktierungsschichten, wobei jede Kontaktierungsschicht wiederum aus mehreren Schichten eines Dielektrikums besteht. Aus EP 1 111 674 A2 ist eine weitere gattungsgemäße Leiterplatte mit alle Merkmalen des Oberbegriffs des Patentanspruchs 1 bekannt.

Es ist somit Aufgabe der Erfindung eine Anordnung anzugeben, mit welcher unter Berücksichtigung eines einfachen Aufbaus und kurzer Signalwege die Bestückungsdichte einer Leiterplatte mit SMD-Bauteilen erhöht werden kann.

Diese Aufgabe wird mit der Anordnung gemäß Patentanspruch 1 gelöst. Vorteilhafte Ausführungen der Erfindung sind Gegenstand von Unteransprüchen.

Die Anordnung zur Erhöhung der Bestückungsdichte einer Leiterplatte mit oberflächenmontierbaren elektrischen Bauteilen umfasst erfindungsgemäß eine durch zwei gegeneinander mit einem dazwischen angeordneten Dielektrikum verpresste elektrisch leitende Folien, welche mit oberflächenmontierbaren elektrischen Bauteilen bestückt sind gebildete Leiterplatte, wobei zur Verbindung der beiden Folien in der Leiterplatte via holes vorhanden sind, wobei jedes via hole eine direkte Verbindung der sich gegenüberliegenden Seiten der Folien ist. Gemäß der Erfindung sind die sich gegenüberliegenden Seiten der Folien mit oberflächenmontierbaren elektrischen Bauteilen bestückt, so daß sich die elektrischen Bauteile gegenüberliegen.

Mit dieser Anordnung ist eine wesentlich höhere Bestückungsdichte der Leiterplatte möglich, da SMD-Bauteile im Inneren der Leiterplatte angeordnet sind. Außerdem ist es mit der erfindungsgemäßen Anordnung möglich, die Signalwege zwischen den SMD-Bauteilen zu verringern.
Die Via holes sind Bohrungen und können insbesondere Mikrovias sein und können mittels Bohr-, Galvanisieren- oder Ätzverfahren hergestellt werden.

In einer ersten vorteilhaften Ausführungsform der Erfindung sind auf den sich nicht gegenüberliegenden Seiten der Folien weitere SMD-Bauteile angeordnet. Dadurch lässt sich die Bestückungsdichte der Leiterplatte mit SMD-Bauteilen weiter erhöhen. Die eingesetzten Folien sind vorteilhaft Cu-haltig. Es sind aber selbstverständlich auch andere Materialien mit einer hohen elektrischen Leitfähigkeit einsetzbar.

In einer zweiten vorteilhaften Ausführungsform weist die Leiterplatte erste Kontaktierungen auf, welche auf mindestens einer Seite der Leiterplatte ausgeführt sind. Mit diesen Kontaktierungen können z.B. elektrische Verbindungen zu anderen Leiterplatten hergestellt werden. Diese elektrische Verbindungen können z.B. Bondverbindungen oder Lötverbindungen zu anderen Leiterplatten oder elektrischen Bauteilen z.B.
Mikrochips sein.

In einer weiteren vorteilhaften Ausführungsform der Erfindung weist auf mindestens einer Seite der Leiterplatte eine weitere Schicht eines Dielektrikums sowie eine weitere Folie aufgebracht ist.

Eine weitere vorteilhafte Ausführungsform ist eine Stapelung der erfindungsgemäßen Leiterplattenanordnungen.

### Die Erfindung wird im weiteren anhand von Zeichnungen näher erläutert. Es zeigen:

- Fig. 1: eine erste beispielhafte Ausführungsform einer erfindungsgemäßen Leiterplatte mit SMD-Bauteilen, welche auf einer Seite einer Folie aufgebracht sind,
- Fig. 2: eine zweite beispielhafte Ausführungsform einer erfindungsgemäßen Leiterplatte mit SMD-Bauteilen, welche auf den sich zugewandten Seiten der beiden Folien aufgebracht sind,
- Fig. 3: eine erfindungsgemäße Leiterplatte der zweiten beispielhaften Ausführungsform mit Kontaktierungen,
- Fig. 4: eine weitere beispielhafte Ausführungsform einer erfindungsgemäßen Leiterplatte mit weiteren Schichten aus Dielektrikum und Folie.

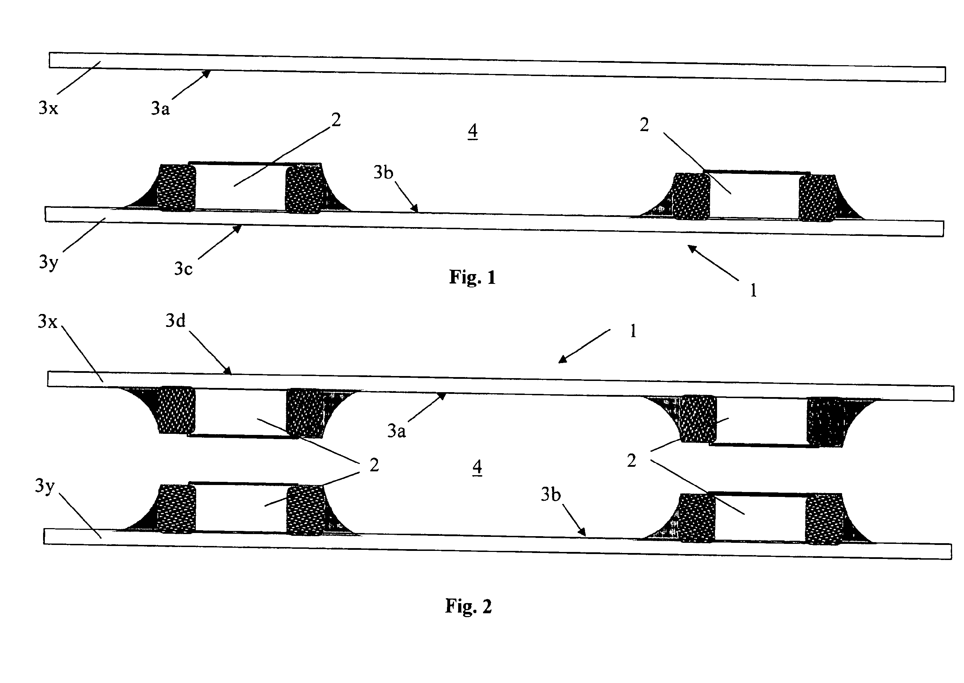

Fig. 1 zeigt in einem senkrechten Schnitt durch eine Leiterplatte eine Leiterplatte 1 mit SMD-Bauteilen 2, welche auf der Innenseite 3a einer Folie 3x,3y angebracht sind. Die SMD-Bauteile 2 sind zwischen zwei Folien 3x,3y angeordnet und in ein Dielektrikum 4 eingebettet. Die Verbindung zwischen dem SMD-Bauteil 2 und der Folie 3x,3y ist eine Lötverbindung 5.
Fig. 2 zeigt in einem senkrechten Schnitt durch eine Leiterplatte eine Ausführungsform einer erfindungsgemäßen Leiterplatte mit SMD-Bauteilen 2, welche auf den Innenseiten 3a,3b beider Folien angebracht sind.

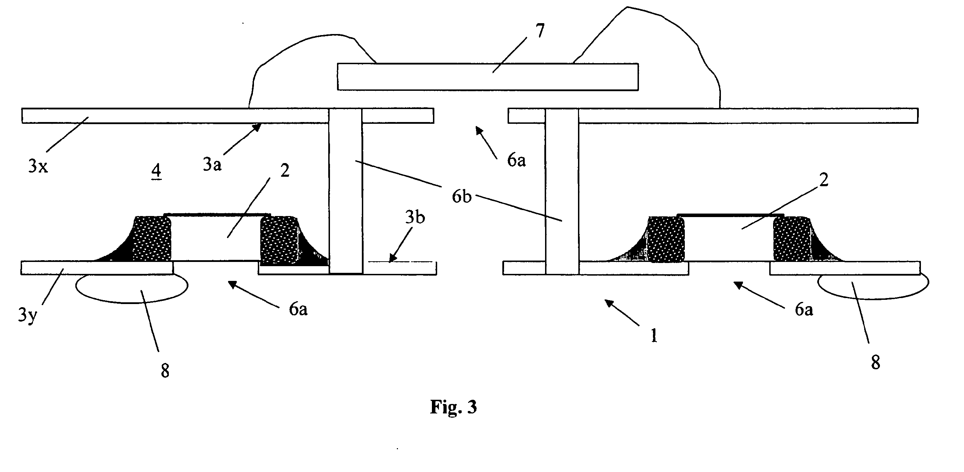

Fig. 3 zeigt in einem senkrechten Schnitt durch eine Leiterplatte eine Leiterplatte 1 mit Kontaktierungen 6a,6b. Dabei sind erste Kontaktierungen 6a auf den Außenseiten 3c,3d der Folien 3x,3y vorgesehen. An diese Kontaktierungen 6a können z.B. weitere Mikrochips 7 oder weitere Lötverbindungen 8 angebracht werden. Via holes 6b bilden eine direkte Verbindung zwischen den beiden Folien 3x,3y. Somit durchläuft ein Signal auf seinem Weg von einer Folie 3x zur gegenüberliegenden Folie 3y den kürzest möglichen Weg. Das Signal durchläuft hierbei zwischen den beide Folien 3x, 3y ein einziges via hole 6b.

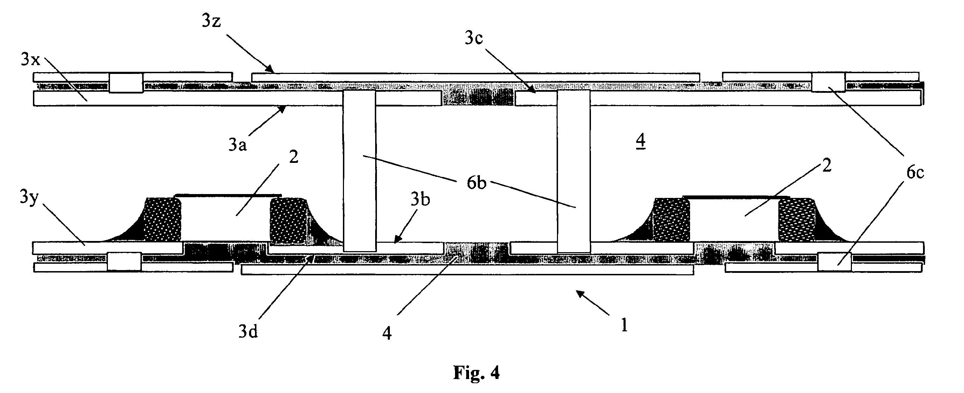

Fig. 4 zeigt in einem senkrechten Schnitt durch eine Leiterplatte eine weitere beispielhafte Ausführungsform einer Leiterplatte 1. Auf den Außenseiten 3c, 3d der verpressten Folien 3x,3y sind weitere Schichten aus Dielektrikum 4 und Folie 3z angebracht. Zwischen den Folien 3z und den verpressten Folien 3x,3y können zweckmäßig Kontaktierungen 6c, z.B. via holes, ausgeführt sein.

## Patentansprüche

1. Anordnung zur Erhöhung der Bestückungsdichte einer Leiterplatte (1) mit oberflächenmontierbaren elektrischen Bauteilen (2),
wobei die Leiterplatte (1) durch zwei gegeneinander mit einem dazwischen angeordneten Dielektrikum (4) verpresste elektrisch leitende Folien (3x, 3y), welche mit oberflächenmontierbaren elektrischen Bauteilen (2) bestückt sind, gebildet ist und wobei zur Verbindung der beiden Folien (3x, 3y) in der Leiterplatte (1) via holes (6b) vorhanden sind, wobei jedes via hole (6b) eine direkte Verbindung der sich gegenüberliegenden Seiten (3a, 3b) der Folien (3x, 3y) ist,
**dadurch gekennzeichnet, dass**
die sich gegenüberliegenden Seiten (3a, 3b) der Folien (3x,3y) mit oberflächenmontierbaren elektrischen Bauteilen (2) bestückt sind, so daß sich die elektrischen Bauteile (2) gegenüberliegen.

2. Anordnung nach Anspruch 1, **dadurch gekennzeichnet, dass** auf den sich nicht gegenüberliegenden Seiten (3c, 3d) der Folien (3x,3y) weitere oberflächenmontierbare elektrische Bauteile (2) angeordnet sind.

3. Anordnung nach einem der vorangehenden Ansprüche, **dadurch gekennzeichnet, dass** auf mindestens einer Seite (3c, 3d) der Leiterplatte (1) eine weitere Schicht eines Dielektrikums (4) sowie eine weitere Folie (3z) aufgebracht ist.

4. Anordnung nach einem der vorangehenden Ansprüche, **dadurch gekennzeichnet, dass** die Folien (3x,3y,3z) Cu-haltig sind.

5. Anordnung nach einem der vorangehenden Ansprüche, **dadurch gekennzeichnet, dass** die Leiterplatte (1) erste Kontaktierungen (6a) aufweist, welche auf mindestens einer Seite (3c, 3d) der Leiterplatte (1) ausgeführt sind.

6. Anordnung nach einem der Ansprüche 3-5, **dadurch gekennzeichnet, dass** zwischen den verpressten Folien (3x,3y) und der weiteren Folie (3z) via holes (6c) ausgeführt sind.

7. Anordnung nach einem der vorangehenden Ansprüche, **dadurch gekennzeichnet, dass** die oberflächenmontierbaren elektrischen Bauteile (2) Widerstände, Spulen oder Kondensatoren sind.

8. Stapel mit mehreren aufeinander angeordneten Leiterplatten anordungen (1) nach einem der vorangehenden Ansprüche.

## Claims

1. Arrangement for increasing the population density of a printed circuit board (1) with surface-mountable electrical components (2),
wherein the printed circuit board (1) is formed by two electrically conductive sheets (3x, 3y) pressed against one another with a dielectric (4) arranged therebetween, said sheets being populated with surface-mountable electrical components (2), and wherein via holes (6b) are present for connecting the two sheets (3x, 3y) in the printed circuit board (1), wherein each via hole (6b) is a direct connection of the mutually opposite sides (3a, 3b) of the sheets (3x, 3y),
**characterized in that**
those sides (3a, 3b) of the sheets (3x, 3y) which lie opposite one another are populated with surface-mountable electrical components (2) such that the electrical components (2) lie opposite one another.

2. Arrangement according to Claim 1, **characterized in that** further surface-mountable electrical components (2) are arranged on those sides (3c, 3d) of the sheets (3x, 3y) which do not lie opposite one another.

3. Arrangement according to any of the preceding claims, **characterized in that** a further layer of a dielectric (4) and also a further sheet (3z) are applied on at least one side (3c, 3d) of the printed circuit board (1).

4. Arrangement according to any of the preceding claims, **characterized in that** the sheets (3x, 3y, 3z) contain Cu.

5. Arrangement according to any of the preceding claims **characterized in that** the printed circuit board (1) has first contact-connections (6a) embodied on at least one side (3c, 3d) of the printed circuit board (1).

6. Arrangement according to any of Claims 3-5, **characterized in that** via holes (6c) are embodied between the pressed sheets (3x, 3y) and the further sheet (3z).

7. Arrangement according to any of the preceding claims, **characterized in that** the surface-mountable electrical components (2) are resistors, coils or capacitors.

8. Stack comprising a plurality of printed circuit board arrangements (1) according to any of the preceding claims that are arranged one on top of another.

## Revendications

1. Arrangement pour accroître la densité d'implantation sur un circuit imprimé (1) de composants électriques (2) à montage en surface, le circuit imprimé (1) étant formé par deux feuilles (3x, 3y) électriquement conductrices comprimées l'une contre l'autre en intercalant un diélectrique (4) et qui sont équipées de composants électriques (2) à montage en surface et des trous traversants (6b) étant présents dans le circuit imprimé (1) pour relier les deux feuilles (3x, 3y), chaque trou traversant (6b) étant une liaison directe des côtés opposés (3a, 3b) des feuilles (3x, 3y), **caractérisé en ce que** les côtés opposés (3a, 3b) des feuilles (3x, 3y) sont équipés de composants électriques (2) à montage en surface de sorte que les composants électriques (2) sont opposés.

2. Arrangement selon la revendication 1,
**caractérisé en ce que** des composants électriques (2) à montage en surface supplémentaires sont disposés sur les côtés non opposés (3c, 3d) des feuilles (3x, 3y).

3. Arrangement selon l'une des revendications précédentes, **caractérisé en ce qu'**une couche diélectrique (4) ainsi qu'une feuille (3z) supplémentaires sont appliquées sur au moins un côté (3c, 3d) du circuit imprimé (1).

4. Arrangement selon l'une des revendications précédentes, **caractérisé en ce que** les feuilles (3x, 3y, 3z) contiennent du cuivre.

5. Arrangement selon l'une des revendications précédentes, **caractérisé en ce que** le circuit imprimé (1) présente des premiers moyens de contact (6a) qui sont exécutés sur au moins un côté (3c, 3d) du circuit imprimé (1).

6. Arrangement selon l'une des revendications 3 à 5, **caractérisé en ce que** des trous traversants (6c) sont exécutés entre les feuilles compressées (3x, 3y) et la feuille supplémentaire (3z).

7. Arrangement selon l'une des revendications précédentes, **caractérisé en ce que** les composants électriques (2) à montage en surface sont des résistances, des inductances ou des condensateurs.

8. Pile comprenant plusieurs arrangements de circuits imprimés (1) selon l'une des revendications précédentes disposés les uns sur les autres.
